# EUROPEAN PATENT SPECIFICATION

(11) **EP 3 200 233 B1**
(45) Date of publication and mention of the grant of the patent: **03.07.2019**
(21) Application number: 15793671.7
(22) Date of filing: 13.01.2015
(51) Int. Cl.: G02B 1/11, G02B 5/30, G02B 27/28, H01L 51/52

(54) **LIGHT-EMITTING DIODE DISPLAY PANEL AND MANUFACTURING METHOD THEREFOR**
LEUCHTDIODENANZEIGETAFEL UND HERSTELLUNGSVERFAHREN DAFÜR
ÉCRAN D'AFFICHAGE À DIODES ÉLECTROLUMINESCENTES ET PROCÉDÉ DE FABRICATION CORRESPONDANT

(30) Priority: 23.09.2014 CN 201410492129
(43) Date of publication of application: 02.08.2017
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: YANG, Falu, Beijing 100176 (CN); ZHANG, Junrui, Beijing 100176 (CN)
(74) Representative: Fritzsche, Thomas
(86) International application number: PCT/CN2015/070616
(87) International publication number: WO 2016/045260

(56) References cited:
- CN-A- 101 777 289
- CN-A- 101 783 360
- CN-A- 102 709 309
- CN-A- 102 769 024
- US-A1- 2004 051 445
- US-A1- 2005 035 353
- US-A1- 2010 019 662
- US-A1- 2010 052 528
- US-A1- 2010 176 382
- US-A1- 2010 320 494
- US-A1- 2012 007 106
- US-A1- 2012 280 259
- US-A1- 2012 327 336
- US-A1- 2013 242 212
- US-B2- 8 684 780

## Description

### FIELD OF THE DISCLOSURE

The present disclosure relates to the field of display technology, and more particularly to a light-emitting diode display panel and a method of fabricating same.

### BACKGROUND OF THE DISCLOSURE

The light-emitting diode display panel stands for a trend for development of display products, especially the organic light-emitting display panel, which has a range of advantages such as being wide in viewing angle, fast in response speed, high in brightness, high in contrast, bright in colors, light in weight, thin in thickness, low in power consumption, and the like.

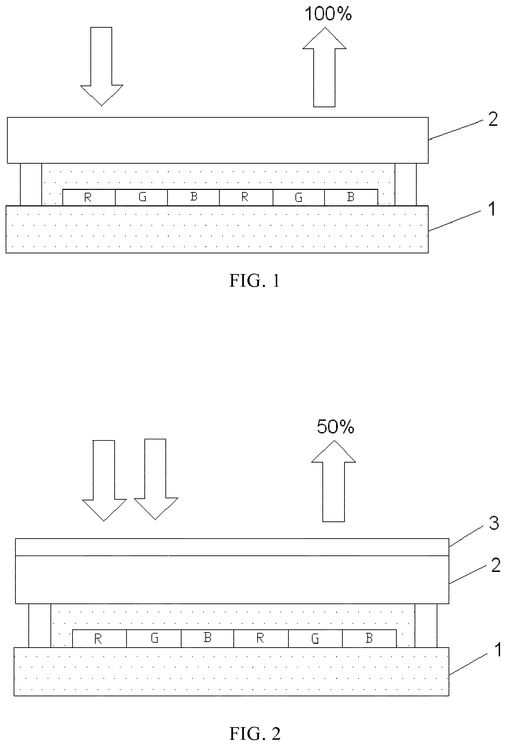

FIG. 1 is a structural schematic diagram of an existing light-emitting diode display panel. The light-emitting diode display panel comprises a first substrate 1 and a second substrate 2. The first substrate 1 contains inherent constructions of a light-emitting diode display panel such as an anode, a cathode, a light-emitting layer, a color filter layer, a hole injection layer, a hole transporting layer, an electron transporting layer, a protective film and the like. The light-emitting diode display panel as illustrated in FIG. 1 is readily affected by ambient light, since a region where metal is contained in the first substrate 1 (i.e., a metallic region) reflects 100% of the ambient light as indicated by the arrow in FIG. 1, which has a significant impact on a light path and colors of the light-emitting diode display panel, thereby affecting the display quality.

At present, a common improvement approach is to provide a polarizer 3 at an outer side of the second substrate 2 as illustrated in FIG. 2. The ambient light is converted into linear polarized light after passing through the polarizer 3, and exits as linear polarized light after being reflected by the metallic region with a reflective index of about 50%. While the light-emitting diode display panel has a somewhat decreased reflective index for the ambient light when being provided with the polarizer 3, about 50% of the ambient light that is reflected still has an impact on the display quality.

US 2012280259 A1 discloses a system for displaying images. The system includes an emissive display device including a plurality of pixel elements arranged in an array. Each pixel element includes a first substrate and a second substrate disposed thereunder, wherein the first substrate includes at least three subpixel regions. At least one patterned polarizer film is disposed between the first and second substrates to be correspondingly located at one of the subpixel regions. At least one retarder film is disposed between the first and second substrates and affixed to the patterned polarizer film.

US 2012327336 A1 discloses an organic light emitting display device to prevent deterioration of visibility caused by reflection of incident light and color transition at high viewing angle, and improve transmittance. The organic light emitting display device includes an organic light emitting display panel, and an antireflective member adhered to an outer surface of the organic light emitting display panel, the antireflective member including a reactive liquid crystal layer and a polarizer film which are laminated in this order, wherein the reactive liquid crystal layer has a λ/4 retardation with respect to a transmitted light of the polarizer film.

US 2013242212 A1 discloses a mirror switchable organic light emitting display including an organic light emitting display panel, a switchable quarter-wave phase retardation panel, a light transflective layer, and a polarizing plate. The switchable quarter-wave phase retardation panel having a first surface and a second surface, is disposed at a light output surface of the organic light emitting display panel, wherein the first surface faces the organic light emitting display panel. The light transflective layer is disposed at the first surface of the quarter-wave phase retardation panel and faces the organic light emitting display panel. The polarizing plate is disposed on the second surface of the quarter-wave phase retardation panel.US 2012007106 A1 discloses an organic light emitting diode (OLED) display including an organic light emitting display panel that includes an organic light emitting member, a polarizing plate that is spaced-apart from the organic light emitting display panel and arranged at an upper portion thereof, and a window that is attached to an upper portion of the polarizing plate and protects the organic light emitting display panel. The polarizing plate may include a linear polarizing member and a retardation film that is disposed under the linear polarizing member.

US 2010320494 A1 discloses a polarizer for organic light emitting diodes (OLED) having improved brightness. The polarizer, which comprises a linear polarizer and a 1/4 retardation plate, comprises a reflective polarizer film disposed between the linear polarizer and the 1/4 retardation plate and transmitting a polarized light horizontal to the transmission axis of the linear polarizer while reflecting a polarized light vertical to the transmission axis of the linear polarizer.

US 2010052528 A1 discloses an organic light emitting diode (OLED) display including a substrate member, an organic light emitting element on the substrate member, and a liquid crystal polymer layer on the organic light emitting element, wherein the liquid crystal polymer layer is configured to delay a phase of light passing therethrough.

US 2005035353 A1 discloses light emitting displays which produce a bright image by efficiently emitting light radiated from a light-emitting thin-film layer to the viewer side, and also produce a high-quality image of high contrast ratio and changing in color to a limited extent over a wide viewing angle range even in a bright atmosphere. The light emitting displays are provided with a plurality of light-emitting devices each having a light-emitting thin-film layer and a light reflective surface in this order on the back side, and a circularly polarized light reflective layer which separates incident light into two types of circularly polarized components, one being reflected and the other transmitted by the reflective layer, an optical compensation layer, a quarter-wave plate and a polarizer on the front side.

US 2004051445 A1 discloses a display device having light-emitting devices making up a plurality of pixels placed in a matrix form. The light-emitting devices each possess an emissive layer and a reflective element placed on the rear surface of the emissive layer. The emissive layer possesses a polarization separator which separates the light emitted from the emissive layer into two kinds of polarized components by reflection and transmission, and a phase plate.

US 2010176382 A1 discloses an organic light emitting diode display device constructed with an organic light emitting element including a first electrode, an organic emission layer, and a second electrode sequentially laminated together, a transmittance control layer formed on the organic light emitting element, a selective reflective layer formed on the transmittance control layer, a polarizing plate formed on the selective reflective layer, and a phase retardation plate disposed between the organic light emitting element and the polarizing plate.

### SUMMARY OF THE DISCLOSURE

It is an object of the present disclosure to provide a light-emitting diode display panel and a method of fabricating the same to reduce an impact of ambient light on display quality.

To address this, the present disclosure provides a light-emitting diode display panel comprising a first substrate having a plurality of constructions containing metallic material, thereby defining a metallic region forming a pattern, a second substrate and a polarizer layer, the light-emitting diode display panel further comprising a λ/4 phase retarder film. The polarizer layer and the λ/4 phase retarder film are arranged such that incident ambient light passes in turn through the polarizer layer and the λ/4 phase retarder film to arrive at the first substrate. The polarizer layer is patterned so as to cover only the pattern of the metallic region in the first substrate.

Preferably, an angle between a transmission axis of the polarizer layer and a transmission axis of the λ/4 phase retarder film is 45°.

Preferably, the polarizer layer is arranged at a surface of the second substrate away from the first substrate, and the λ/4 phase retarder film is arranged at a surface of the second substrate adjacent to the first substrate.

Preferably, the polarizer layer is a polarizer.

Preferably, the polarizer layer and the λ/4 phase retarder film are arranged in turn at a surface of the second substrate adjacent to the first substrate.

Preferably, the polarizer layer is a metallic grating layer for converting the ambient light into linear polarized light.

Preferably, the polarizer layer is a dichroic dye molecule layer for converting the ambient light into linear polarized light.

Preferably, a dichroic dye molecule forming the dichroic dye molecule layer comprises at least one of an azo group dichroic dye molecule and an anthraquinonyl dichroic dye molecule.

Preferably, the λ/4 phase retarder film comprises an alignment layer and a liquid crystal polymer layer arranged over the alignment layer, an angle between an alignment direction of the alignment layer and a transmission axis of the polarizer layer being 45°.

The present disclosure also provides a method of fabricating a light-emitting diode display panel, the light-emitting diode display panel comprising a first substrate having a plurality of constructions containing metallic material, thereby defining a metallic region forming a pattern, the light-emitting diode display panel further comprising a second substrate, the method comprising steps of:
arranging a polarizer layer at a surface of the second substrate away from the first substrate, and arranging a λ/4 phase retarder film at a surface of the second substrate adjacent to the first substrate;
or, arranging a polarizer layer and a λ/4 phase retarder film in turn at a surface of the second substrate adjacent to the first substrate;
or, arranging a λ/4 phase retarder film and a polarizer layer in turn at a surface of the second substrate away from the first substrate; and
cutting the second substrate and the first substrate for cell alignment;
wherein the polarizer layer and the λ/4 phase retarder film are arranged such that incident ambient light passes in turn through the polarizer layer and the λ/4 phase retarder film to arrive at the first substrate, and
wherein the polarizer layer is patterned so as to cover only the pattern of the metallic region in the first substrate.

Preferably, an angle between a transmission axis of the polarizer layer and a transmission axis of the λ/4 phase retarder film is 45°.

The present disclosure effectively prevents the impact of reflection of the ambient light on the displayed image and thus improves the display quality, by arranging both the polarizer layer and the λ/4 phase retarder film in the light-emitting diode display panel.

### BRIEF DESCRIPTION OF THE DRAWINGS

The accompanying drawings are provided for a better understanding of the present disclosure and form a part of the specification for illustration and not limitation of the present disclosure in connection with the detailed description below. In the drawings:
FIG. 1 is a structural schematic diagram of an existing light-emitting diode display panel;
FIG. 2 is a structural schematic diagram of another existing light-emitting diode display panel;
FIG. 3 is a structural schematic diagram of a light-emitting diode display panel according to an embodiment of the present disclosure;
FIG. 4 is a schematic diagram of a light path of the construction as shown in FIG. 3;
FIG. 5 is a plan view of a polarizer layer of FIG. 3;
FIG. 6 is a plan view of a liquid crystal polymer layer of FIG. 3;
FIG. 7 is a structural schematic diagram of a light-emitting diode display panel according to another embodiment of the present disclosure;
FIG. 8 is a schematic diagram of a light path of the construction as shown in FIG. 7; and
FIG. 9 is a plan view of a polarizer layer having a pattern.

### DETAILED DESCRIPTION

Embodiments of the present disclosure are described in detail in connection with the accompanying drawings. It is to be understood that the described embodiments herein are for illustration and explanation purposes only, and not for limitation of the present disclosure.

The present disclosure provides a light-emitting diode display panel comprising a first substrate, a second substrate and a polarizer layer, the light-emitting diode display panel further comprising a λ/4 phase retarder film. The polarizer layer and the λ/4 phase retarder film are arranged such that incident ambient light arrives at the first substrate after passing through the polarizer layer and the λ/4 phase retarder film in turn.

Here the light-emitting diode display panel may be an organic light-emitting diode (OLED) display panel, or it may be an active matrix organic light-emitting diode (AMOLED) display panel. In the disclosure, the first substrate may be used for display, and the second substrate may be used for encapsulation of the first substrate. For example, the first substrate may be a display substrate which contains constructions such as an anode, a cathode, a light-emitting layer, a color filter layer, a hole injection layer, a hole transporting layer, an electron transporting layer, an array of thin-film transistors, a protective film, and the like; the second substrate may be a cover plate for encapsulation purposes only. Therein, a plurality of constructions in the first substrate, such as the anode, the cathode, the array of thin-film transistors and the like, contain metallic materials. A region where the metallic materials are located is referred to here as a metallic region. The metallic region in the first substrate can reflect ambient light incident on the first substrate, and thus has an impact on the display effect.

In the present disclosure, the incident ambient light is converted into linear polarized light after passing through the polarizer layer, and into circular polarized light or elliptical polarized light after passing through the λ/4 phase retarder film. If an angle between a transmission axis of the polarizer layer and a transmission axis of the λ/4 phase retarder film is 45°, the circular polarized light is produced; otherwise the elliptical polarized light is produced. A change in handedness occurs to the circular polarized light or elliptical polarized light when it arrives at the first substrate and is reflected by the metallic region. For example, left-handed circular polarized light will be converted into right-handed circular polarized light, and then into linear polarized light whose polarization is perpendicular to the previous polarization after passing again through the λ/4 phase retarder film, and thus it cannot transmit through the polarizer layer. Therefore, the impact of reflection of the ambient light on the displayed image is significantly reduced, resulting in an improved display quality.

Preferably, the angle between the transmission axis of the polarizer layer and the transmission axis of the λ/4 phase retarder film is 45°. In this case, the exiting ambient light comprises only linear polarized light whose polarization is perpendicular to the transmission axis of the polarizer layer, such that no ambient light can transmit through the polarizer layer, i.e. a reflective index of the incident ambient light is 0%, leading to avoidance of the impact of the ambient light on the display quality.

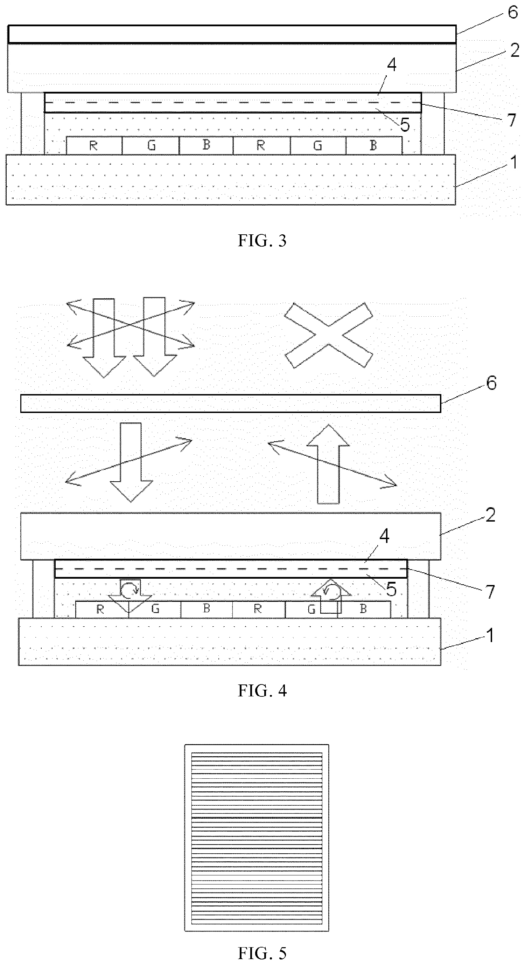

FIG. 3 is a structural schematic diagram of a light-emitting diode display panel according to an embodiment of the present disclosure. In FIG. 3, the polarizer layer 6 is arranged at a surface of the second substrate 2 away from the first substrate 1 (i.e., at an outer side of the second substrate 2), and the λ/4 phase retarder film 7 is arranged at a surface of the second substrate 2 adjacent to the first substrate 1 (i.e., at an inner side of the second substrate 2). The ambient light is incident from above the polarizer layer 6 and passes in turn through the polarizer layer 6, the second substrate 2 and the λ/4 phase retarder film 7 to shine on the first substrate 1.

The polarizer layer 6 in this embodiment is not limited to any specific form, as long as it can convert the ambient light into linear polarized light. The polarizer layer 6 in FIG. 3 is arranged at the outer side of the second substrate 2, in which case the polarizer layer 6 is preferably a conventional polarizer so as to simplify the manufacturing procedure and to save cost.

The λ/4 phase retarder film 7 may be achieved by forming an alignment layer 4 and a liquid crystal polymer layer 5 in turn at the inner side of the second substrate 2. With the angle between the transmission axis of the polarizer layer 6 and the transmission axis of the λ/4 phase retarder film 7 being preferably 45°, an angle between an alignment direction of the alignment layer 4 and the transmission axis of the polarizer layer 6 may be arranged to be 45°.

The alignment layer 4 may be formed by way of friction, or it may be formed by way of photo-induced alignment. The liquid crystal polymer layer 5 is formed by liquid crystal reactive monomers through ultraviolet curing.

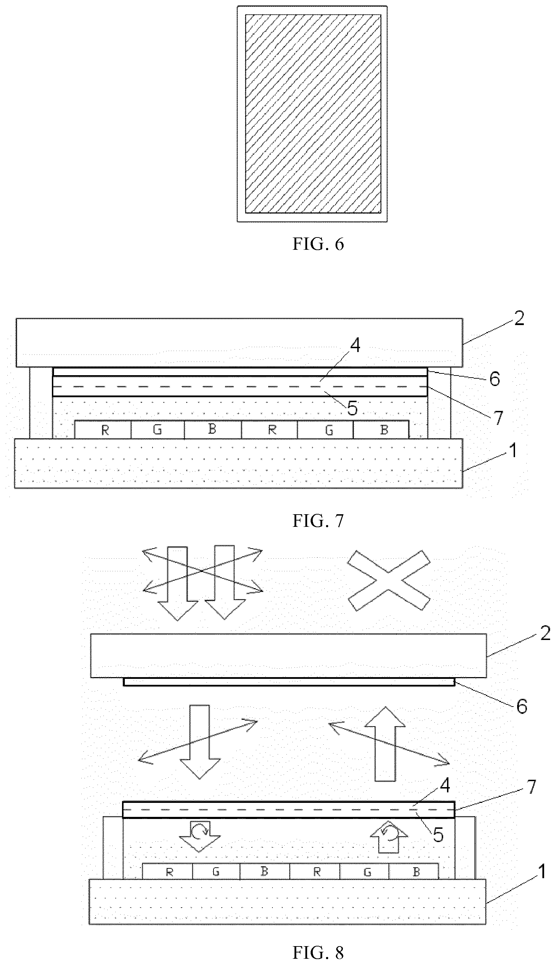

FIG. 4 is a schematic diagram of a light path of the construction as shown in FIG. 3. Assuming that the transmission axis of the polarizer layer 6 is at 0°, then the incident ambient light is converted into linear polarized light of 0° after passing through the polarizer layer 6 as shown in FIG. 5. The transmission axis of the λ/4 phase retarder film 7 is preferably orientated at 45° to form an angle of 45° with the transmission axis of the polarizer layer 6. Here the alignment direction of the alignment layer 4 may be arranged to be 45°, and then the liquid crystal polymer layer 5 may be arranged over the alignment layer 4. A plan view of the arranged liquid crystal polymer layer 5 is shown in FIG. 6.

Upon passing through the λ/4 phase retarder film 7 formed by the alignment layer 4 and the liquid crystal polymer layer 5, the linear polarized light of 0° is converted into left-handed circular polarized light. The left-handed circular polarized light is then converted into right-handed circular polarized light upon reflection by the metallic region in the first substrate 1. Upon passing again through the λ/4 phase retarder film 7, the right-handed circular polarized light is converted into linear polarized light of 90° that cannot transmit through the polarizer layer 6 with a transmission axis of 0°, resulting in a reflective index of 0% against the incident ambient light. This eliminates the impact of reflection of the ambient light on the display effect of the display panel, and hence improves the display quality.

FIG. 7 is a schematic diagram of a light-emitting diode display panel according to another embodiment of the present disclosure. In FIG. 7, the polarizer layer 6 and the λ/4 phase retarder film 7 are arranged in turn at a surface of the second substrate 2 adjacent to the first substrate 1 (i.e., at the inner side of the second substrate 2). The ambient light is incident from above the second substrate 2, passing in turn through the second substrate 2, the polarizer layer 6 and the λ/4 phase retarder film 7 to shine on the first substrate 1.

The polarizer layer 6 in this embodiment is not limited to any specific form, as long as it can convert the ambient light into linear polarized light. The polarizer layer 6 in FIG. 7 is arranged at the inner side of the second substrate 2, in which case the polarizer layer 6 is preferably a metallic grating layer or dichroic dye molecule layer capable of converting the ambient light into linear polarized light. A thin metallic grating layer or dichroic dye molecule layer facilitates restriction of the thickness of the display panel as a whole, allowing it to be in line with the trend of light weight.

For a dichroic dye molecule, it can absorb one of the two orthogonal components of the linear polarization in the incident ambient light, allowing the other one to transmit. Therefore, the dichroic dye molecule layer may achieve a function of light conversion in place of a polarizer. In the present disclosure, a dichroic dye molecule forming the dichroic dye molecule layer may be any of an azo group dichroic dye molecule and an anthraquinonyl dichroic dye molecule or combination thereof.

The molecular formula of the azo group dichroic dye molecule is shown as follows:

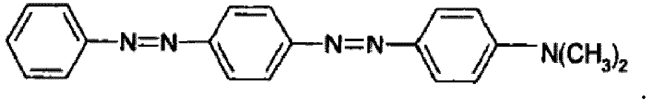

The molecular formula of the anthraquinonyl dichroic dye molecule is shown as follows:

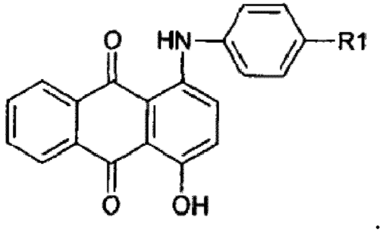

In the embodiment as shown in FIG. 7, the λ/4 phase retarder film 7 can be achieved by forming in turn the alignment layer 4 and the liquid crystal polymer layer 5 over the polarizer layer 6. With the angle between the transmission axis of the polarizer layer 6 and the transmission axis of the λ/4 phase retarder film 7 being preferably 45°, the angle between the alignment direction of the alignment layer 4 and the transmission axis of the polarizer layer 6 may be arranged to be 45°.

Likewise, the alignment layer 4 may be formed by way of friction, or it may be formed by way of photo-induced alignment. The liquid crystal polymer layer 5 is formed by liquid crystal reactive monomers through ultraviolet curing.

FIG. 8 is a schematic diagram of a light path of the construction as shown in FIG. 7. Assuming that the transmission axis of the polarizer layer 6 is at 0°, then the incident ambient light is converted into linear polarized light of 0° after passing through the polarizer layer 6. The transmission axis of the λ/4 phase retarder film 7 is preferably orientated at 45° to form an angle of 45° with the transmission axis of the polarizer layer 6. Here the alignment direction of the alignment layer 4 may be arranged to be 45°, and then the liquid crystal polymer layer 5 may be arranged over the alignment layer 4, forming the λ/4 phase retarder film 7 with a transmission axis of 45°.

Upon passing through the λ/4 phase retarder film 7 formed by the alignment layer 4 and the liquid crystal polymer layer 5, the linear polarized light of 0° is converted into left-handed circular polarized light. The left-handed circular polarized light is then converted into right-handed circular polarized light upon reflection by the metallic region in the first substrate 1. Upon passing again through the λ/4 phase retarder film 7, the right-handed circular polarized light is converted into linear polarized light of 90° that cannot transmit through the polarizer layer 6 with a transmission axis of 0°, resulting in a reflective index of 0% against the incident ambient light. This eliminates the impact of reflection of the ambient light on the display effect of the display panel, and hence improves the display quality.

In the present disclosure, the arrangement of the λ/4 phase retarder film and the polarizer layer is not limited to any specific configuration, as long as the ambient light passes in turn through the polarizer layer and the λ/4 phase retarder film to arrive at the first substrate or the metallic region therein. For example, the λ/4 phase retarder film and the polarizer layer may also be arranged in turn at the outer side of the second substrate, i.e., the λ/4 phase retarder film is firstly arranged at the outer side of the second substrate, and then the polarizer layer is arranged at outer side of the λ/4 phase retarder film. The principle of the light path is the same as the above-mentioned two embodiments, which will not be discussed here in detail. Furthermore, since the polarizer layer is arranged at the outer side of the second substrate, it is preferably in a form of a polarizer.

Further, the polarizer layer in the present disclosure may be that which has a pattern corresponding to a pattern of the metallic region in the first substrate. As mentioned above, a plurality of constructions in the first substrate, such as the anode, the cathode, the array of thin-film transistors and the like, contain metallic materials, with the region where the metallic materials are located being referred to as the metallic region. The metallic region generally has a predetermined pattern. Where the pattern of the polarizer layer corresponds to the pattern of the metallic region in the first substrate, a brightness of the display panel can be increased, and materials for fabricating the polarizer layer can be saved.

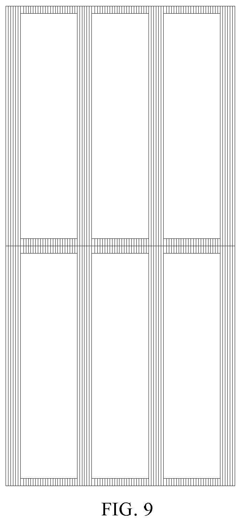

In the present disclosure, the pattern of the polarizer layer may correspond to the pattern of a metallic region formed by metallic material in a certain layered construction of the first substrate, or it may correspond to an accumulation of patterns of the metallic regions formed by all the metallic materials in the first substrate. For example, FIG. 9 is a plan view of a polarizer layer having a pattern, in which the pattern of the polarizer layer corresponds to a periphery of a display region, and to a metallic region formed by the metallic electrodes in the array of thin-film transistors.

The present disclosure also provides in another aspect a method of fabricating the above-mentioned light-emitting diode display panel, the light-emitting diode display panel comprising a first substrate and a second substrate, the method comprising steps of:
S1: arranging a polarizer layer at a surface of the second substrate away from the first substrate (i.e., at an outer side of the second substrate), and arranging a λ/4 phase retarder film at a surface of the second substrate adjacent to the first substrate (i.e., at an inner side of the second substrate);
or, arranging a polarizer layer and a λ/4 phase retarder film in turn at an inner side of the second substrate;
or, arranging a λ/4 phase retarder film and a polarizer layer in turn at an outer side of the second substrate; and
S2: cutting the second substrate and the first substrate for cell alignment;
wherein the polarizer layer and the λ/4 phase retarder film are arranged such that incident ambient light passes in turn through the polarizer layer and the λ/4 phase retarder film to arrive at the first substrate.

Preferably, an angle between a transmission axis of the polarizer layer and a transmission axis of the λ/4 phase retarder film is 45°.

The incident ambient light is converted into linear polarized light after passing through the polarizer layer, and into circular polarized light after passing through the λ/4 phase retarder film. A change in handedness occurs to the circular polarized light when it arrives at the first substrate and is reflected by a metallic region in the first substrate. For example, left-handed circular polarized light will be converted into right-handed circular polarized light, and then into linear polarized light whose polarization is perpendicular to the previous polarization after passing again through the λ/4 phase retarder film, and thus it cannot transmit through the polarizer layer. The present disclosure effectively reduces the impact of reflection of the ambient light on the displayed image, resulting in an improved display quality.

The polarizer layer may be a polarizer, a metallic grating layer, a dichroic dye molecule layer, or any other layered construction that is able to convert the ambient light into linear polarized light. In case the polarizer layer is arranged at the outer side of the second substrate, it is preferably a polarizer for the purpose of reduced difficulty of process and saved cost. In case the polarizer layer is arranged at the inner side of the second substrate, it is preferably a metallic grating layer or a dichroic dye molecule layer so as to maintain the thickness of the display panel at a low level.

The λ/4 phase retarder film may comprise an alignment layer and a liquid crystal polymer layer arranged over the alignment layer, with the liquid crystal polymer layer formed by liquid crystal reactive monomers through ultraviolet curing. Preferably, an angle between an alignment direction of the alignment layer and a transmission axis of the polarized layer is 45°.

The present disclosure effectively prevents the impact of reflection of the ambient light on the displayed image and thus improves the display quality, by arranging both the polarizer layer and the λ/4 phase retarder film in the light-emitting diode display panel.

It is to be understood that the embodiments above are exemplary embodiments for illustration of the principle of the present disclosure only; however, the present disclosure is not limited thereto. Various variations and modifications can be made by the skilled in the art without departing from the spirit and scope of the present disclosure, which are considered within the protection scope of the present disclosure.

## Claims

1. A light-emitting diode display panel, comprising:
a first substrate (1) having a plurality of constructions containing metallic material, thereby defining a metallic region forming a pattern;
a second substrate (2);
a polarizer layer (6); and
a λ/4 phase retarder film (7),
wherein the polarizer layer (6) and the λ/4 phase retarder film (7) are arranged such that incident ambient light passes in turn through the polarizer layer (6) and the λ/4 phase retarder film (7) to arrive at the first substrate (1), and
wherein the polarizer layer (6) is patterned so as to cover only the pattern of the metallic region in the first substrate (1).

2. The light-emitting diode display panel as recited in claim 1, wherein an angle between a transmission axis of the polarizer layer (6) and a transmission axis of the λ/4 phase retarder film (7) is 45°.

3. The light-emitting diode display panel as recited in claim 1 or 2, wherein the polarizer layer (6) is arranged at a surface of the second substrate (2) away from the first substrate (1), and wherein the λ/4 phase retarder film (7) is arranged at a surface of the second substrate (2) adjacent to the first substrate (1).

4. The light-emitting diode display panel as recited in claim 3, wherein the polarizer layer (6) is a polarizer.

5. The light-emitting diode display panel as recited in claim 1 or 2, wherein the polarizer layer (6) and the λ/4 phase retarder film (7) are arranged in turn at a surface of the second substrate (2) adjacent to the first substrate (1).

6. The light-emitting diode display panel as recited in claim 5, wherein the polarizer layer (6) is a metallic grating layer for converting the ambient light into linear polarized light.

7. The light-emitting diode display panel as recited in claim 5, wherein the polarizer layer (6) is a dichroic dye molecule layer for converting the ambient light into linear polarized light.

8. The light-emitting diode display panel as recited in claim 7, wherein a dichroic dye molecule forming the dichroic dye molecule layer comprises at least one of an azo group dichroic dye molecule and an anthraquinonyl dichroic dye molecule.

9. The light-emitting diode display panel as recited in any of claims 1 to 8, wherein the λ/4 phase retarder film (7) comprises an alignment layer (4) and a liquid crystal polymer layer (5) arranged over the alignment layer (4), an angle between an alignment direction of the alignment layer (4) and a transmission axis of the polarizer layer (6) being 45°.

10. A method of fabricating a light-emitting diode display panel, the light-emitting diode display panel comprising a first substrate (1) having a plurality of constructions containing metallic material, thereby defining a metallic region forming a pattern, the light-emitting diode display panel further comprising a second substrate (2), the method comprising steps of:
arranging a polarizer layer (6) at a surface of the second substrate (2) away from the first substrate (1), and arranging a λ/4 phase retarder film (7) at a surface of the second substrate (2) adjacent to the first substrate (1);
or, arranging a polarizer layer (6) and a λ/4 phase retarder film (7) in turn at a surface of the second substrate (2) adjacent to the first substrate (1);
or, arranging a λ/4 phase retarder film (6) and a polarizer layer (7) in turn at a surface of the second substrate (2) away from the first substrate (1); and
cutting the second substrate (2) and the first substrate (1) for cell alignment;
wherein the polarizer layer (6) and the λ/4 phase retarder film (7) are arranged such that incident ambient light passes in turn through the polarizer layer (6) and the λ/4 phase retarder film (7) to arrive at the first substrate (1), and
wherein the polarizer layer (6) is patterned so as to cover only the pattern of the metallic region in the first substrate (1).

11. The method as recited in claim 10, wherein an angle between a transmission axis of the polarizer layer (6) and a transmission axis of the λ/4 phase retarder film (7) is 45°.

## Patentansprüche

1. Leuchtdiodenanzeigetafel, umfassend:
ein erstes Substrat (1), das eine Vielzahl von Konstruktionen aufweist, die metallisches Material enthalten, wodurch ein metallischer Bereich definiert ist, der ein Muster bildet;
ein zweites Substrat (2);
eine Polarisatorschicht (6); und
eine λ/4-Phasenverzögerungsfolie (7),
wobei die Polarisatorschicht (6) und die λ/4-Phasenverzögerungsfolie (7) derartig angeordnet sind, dass einfallendes Umgebungslicht nacheinander durch die Polarisatorschicht (6) und die λ/4-Phasenverzögerungsfolie (7) gelangt, um am ersten Substrat (1) anzukommen, und
wobei die Polarisatorschicht (6) gemustert ist, um nur das Muster des metallischen Bereiches im ersten Substrat (1) abzudecken.

2. Leuchtdiodenanzeigetafel nach Anspruch 1, wobei ein Winkel zwischen einer Durchlässigkeitsachse der Polarisatorschicht (6) und einer Durchlässigkeitsachse der λ/4-Phasenverzögerungsfolie (7) 45° beträgt.

3. Leuchtdiodenanzeigetafel nach Anspruch 1 oder 2, wobei die Polarisatorschicht (6) an einer Fläche des zweiten Substrats (2) entfernt vom ersten Substrat (1) angeordnet ist, und wobei die λ/4-Phasenverzögerungsfolie (7) an einer Fläche des zweiten Substrats (2) angrenzend an das erste Substrat (1) angeordnet ist.

4. Leuchtdiodenanzeigetafel nach Anspruch 3, wobei die Polarisatorschicht (6) ein Polarisator ist.

5. Leuchtdiodenanzeigetafel nach Anspruch 1 oder 2, wobei die Polarisatorschicht (6) und die λ/4-Phasenverzögerungsfolie (7) nacheinander an einer Fläche des zweiten Substrats (2) angrenzend an das erste Substrat (1) angeordnet sind.

6. Leuchtdiodenanzeigetafel nach Anspruch 5, wobei die Polarisatorschicht (6) eine metallische Gitterschicht zum Umwandeln des Umgebungslichts in linear polarisiertes Licht ist.

7. Leuchtdiodenanzeigetafel nach Anspruch 5, wobei die Polarisatorschicht (6) eine Schicht dichroitischer Farbstoffmoleküle zum Umwandeln des Umgebungslichts in linear polarisiertes Licht ist.

8. Leuchtdiodenanzeigetafel nach Anspruch 7, wobei ein dichroitisches Farbstoffmolekül, das die Schicht dichroitischer Farbstoffmoleküle bildet, mindestens eines von einem dichroitischem Azogruppen-Farbstoffmolekül und einem dichroitischen Anthraquinonyl-Farbstoffmolekül ist.

9. Leuchtdiodenanzeigetafel nach einem der Ansprüche 1 bis 8, wobei die λ/4-Phasenverzögerungsfolie (7) eine Ausrichtungsschicht (4) und eine Flüssigkristallpolymerschicht (5) umfasst, die über der Ausrichtungsschicht (4) angeordnet ist, wobei ein Winkel zwischen einer Ausrichtungsrichtung der Ausrichtungsschicht (4) und einer Durchlässigkeitsachse der Polarisatorschicht (6) 45° beträgt.

10. Verfahren zum Herstellen einer Leuchtdiodenanzeigetafel, wobei die Leuchtdiodenanzeigetafel ein erstes Substrat (1) umfasst, das eine Vielzahl von Konstruktionen aufweist, die metallisches Material enthalten, wodurch ein metallischer Bereich definiert ist, der ein Muster bildet, wobei die Leuchtdiodenanzeigetafel ferner ein zweites Substrat (2) umfasst, wobei das Verfahren die folgenden Schritte umfasst:
Anordnen einer Polarisatorschicht (6) an einer Fläche des zweiten Substrats (2) entfernt vom ersten Substrat (1), und Anordnen einer λ/4-Phasenverzögerungsfolie (7) an einer Fläche des zweiten Substrats (2) angrenzend an das erste Substrat (1);
oder Anordnen einer Polarisatorschicht (6) und einer λ/4-Phasenverzögerungsfolie (7) nacheinander an einer Fläche des zweiten Substrats (2) angrenzend an das erste Substrat (1);
oder Anordnen einer λ/4-Phasenverzögerungsfolie (6) und einer Polarisatorschicht (7) nacheinander an einer Fläche des zweiten Substrats (2) entfernt vom ersten Substrat (1); und
Schneiden des zweiten Substrats (2) und des ersten Substrats (1) zur Zellenausrichtung;
wobei die Polarisatorschicht (6) und die λ/4-Phasenverzögerungsfolie (7) derartig angeordnet sind, dass einfallendes Umgebungslicht nacheinander durch die Polarisatorschicht (6) und die λ/4-Phasenverzögerungsfolie (7) gelangt, um am ersten Substrat (1) anzukommen, und
wobei die Polarisatorschicht (6) gemustert ist, um nur das Muster des metallischen Bereiches im ersten Substrat (1) abzudecken.

11. Verfahren nach Anspruch 10, wobei ein Winkel zwischen einer Durchlässigkeitsachse der Polarisatorschicht (6) und einer Durchlässigkeitsachse der λ/4-Phasenverzögerungsfolie (7) 45° beträgt.

## Revendications

1. Écran d'affichage à diodes électroluminescentes, comprenant :
un premier substrat (1) ayant une pluralité de constructions contenant un matériau métallique, définissant ainsi une région métallique formant un motif ;
un second substrat (2) ;
une couche de polariseur (6) ; et
un film retardateur de phase λ/4 (7),
dans lequel la couche de polariseur (6) et le film retardateur de phase λ/4 (7) sont agencés de sorte qu'une lumière ambiante incidente traverse ensuite la couche de polariseur (6) et le film retardateur de phase λ/4 (7) pour arriver au premier substrat (1), et
dans lequel la couche de polariseur (6) respecte un motif de telle sorte qu'elle recouvre uniquement le motif de la région métallique dans le premier substrat (1).

2. Écran d'affichage à diodes électroluminescentes selon la revendication 1, dans lequel un angle entre un axe de transmission de la couche de polariseur (6) et un axe de transmission du film retardateur de phase λ/4 (7) est de 45°.

3. Écran d'affichage à diodes électroluminescentes selon la revendication 1 ou 2, dans lequel la couche de polariseur (6) est agencée à une surface du second substrat (2) éloignée du premier substrat (1), et dans lequel le film retardateur de phase λ/4 (7) est agencé à une surface du second substrat (2) adjacente au premier substrat (1).

4. Écran d'affichage à diodes électroluminescentes selon la revendication 3, dans lequel la couche de polariseur (6) est un polariseur.

5. Écran d'affichage à diodes électroluminescentes selon la revendication 1 ou 2, dans lequel la couche de polariseur (6) et le film retardateur de phase λ/4 (7) sont agencés ensuite à une surface du second substrat (2) adjacente au premier substrat (1).

6. Écran d'affichage à diodes électroluminescentes selon la revendication 5, dans lequel la couche de polariseur (6) est une couche de grille métallique pour convertir la lumière ambiante en lumière polarisée linéaire.

7. Écran d'affichage à diodes électroluminescentes selon la revendication 5, dans lequel la couche de polariseur (6) est une couche de molécule colorante dichroïque pour convertir la lumière ambiante en lumière polarisée linéaire.

8. Écran d'affichage à diodes électroluminescentes selon la revendication 7, dans lequel une molécule colorante dichroïque formant la couche de molécule colorante dichroïque comprend au moins l'une d'une molécule colorante dichroïque de groupe azoïque et d'une molécule colorante dichroïque anthraquinonyle.

9. Écran d'affichage à diodes électroluminescentes selon l'une quelconque des revendications 1 à 8, dans lequel le film retardateur de phase λ/4 (7) comprend une couche d'alignement (4) et une couche polymère de cristaux liquides (5) agencée sur la couche d'alignement (4), un angle entre une direction d'alignement de la couche d'alignement (4) et un axe de transmission de la couche de polariseur (6) étant de 45°.

10. Procédé de fabrication d'un écran d'affichage à diodes électroluminescentes, l'écran d'affichage à diodes électroluminescentes comprenant un premier substrat (1) ayant une pluralité de constructions contenant un matériau métallique, définissant ainsi une région métallique formant un motif, l'écran d'affichage à diodes électroluminescentes comprenant en outre un second substrat (2), le procédé comprenant les étapes suivantes :
l'agencement d'une couche de polariseur (6) à une surface du second substrat (2) éloignée du premier substrat (1), et l'agencement d'un film retardateur de phase λ/4 (7) à une surface du second substrat (2) adjacente au premier substrat (1) ;
ou l'agencement d'une couche de polariseur (6) et d'un film retardateur de phase λ/4 (7) ensuite à une surface du second substrat (2) adjacente au premier substrat (1) ;
ou l'agencement d'un film retardateur de phase λ/4 (6) et d'une couche de polariseur (7) ensuite à une surface du second substrat (2) éloignée du premier substrat (1) ; et
la découpe du second substrat (2) et du premier substrat (1) pour un alignement de cellules ;
dans lequel la couche de polariseur (6) et le film retardateur de phase λ/4 (7) sont agencés de sorte qu'une lumière ambiante incidente traverse ensuite la couche de polariseur (6) et le film retardateur de phase λ/4 (7) pour arriver au premier substrat (1), et
dans lequel la couche de polariseur (6) respecte un motif de telle sorte qu'elle recouvre uniquement le motif de la région métallique dans le premier substrat (1).

11. Procédé selon la revendication 10, dans lequel un angle entre un axe de transmission de la couche de polariseur (6) et un axe de transmission du film retardateur de phase λ/4 (7) est de 45°.
